(19) Europäisches Patentamt / European Patent Office / Office européen des brevets

(11) **EP 4 276 373 A1**

(12) **EUROPEAN PATENT APPLICATION**

(43) Date of publication:
**15.11.2023   Bulletin 2023/46**

(21) Application number: **23165475.7**

(22) Date of filing: **30.03.2023**

(51) International Patent Classification (IPC):
**F24F 11/00** (2018.01)        **F24F 13/24** (2006.01)

(52) Cooperative Patent Classification (CPC):
**F24F 11/0001; F24F 13/24**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **11.05.2022   FI 20225414**

(71) Applicant: **Climecon OY**
**00880 Helsinki (FI)**

(72) Inventor: **HUUSKONEN, Esa**
**02630 Espoo (FI)**

(74) Representative: **Berggren Oy**
**P.O. Box 16**
**Eteläinen Rautatiekatu 10A**
**00101 Helsinki (FI)**

(54)     **METHOD AND COMPUTER PROGRAM PRODUCT FOR SELECTING VENTILATION DEVICES TO A SUSTAINABLE VENTILATION SYSTEM**

(57)     The method for selecting ventilation devices to sustainable ventilation system of a space from a group of ventilation devices comprises steps of determining a design air flow ($Q_d$) for the space, determining design air flow rate ($Q_v$) for the ventilation device, selecting at least one space related technical property for the ventilation devices, determining an approval criterion for the selected said at least one space related technical property and forming a subgroup of ventilation devices from those ventilation devices fulfilling the approval criterion. The method further comprises steps of calculating CO2e (carbon dioxide equivalent) for the ventilation devices in the subgroup, calculating a comparison value CV for the ventilation devices in the subgroup using equation CV = (design air flow rate $Q_v$ of the ventilation device)/(carbon dioxide equivalent (CO2e) of the ventilation device) and using comparison value CV as a first selection criterion when selecting ventilation devices to the ventilation system from the subgroup.

Determining the design air flow of the space

↓

Defining initial number of ventilation devices in the ventilation system

↓

Determining the design air flow of the ventilation device

↓

Selecting at least one space related technical property

↓

Determining an approval criterion for the selected space related technical property

↓

Forming a subgroup of ventilation devices fulfilling the approval criterion

↓

Calculating CO2e for the ventilation devices of the subgroup

↓

Calculating comparison value CV for the ventilation devices of the subgroup

↓

Using comparison value CV as a selection criterion when selecting ventilation devices

Fig.1

EP 4 276 373 A1

## Description

## Technical Field

The invention relates to a method for selecting ventilation devices to a sustainable ventilation system of a space from a group of ventilation devices, said method comprising steps of determining a design air flow for the space Qd, determining a design air flow rate for the ventilation device Qv, selecting at least one space related technical property for the ventilation devices, determining an approval criterion for selected said at least one space related technical property and forming a subgroup of ventilation devices from those ventilation devices fulfilling the approval criterion. The invention further relates to a computer program product, which is configured to perform the steps of the method according to the invention, when the program is executed in a processor of a computer.

## Background Art

A typical ventilation system of a space includes a set of supply air valves and diffusers and a set of exhaust air valves, commonly referred as ventilation devices. The ventilation system of the space is designed such that the group of ventilation devices of the space can supply the calculated supply air into the space and extract corresponding amount of exhaust air from the space. The chosen ventilation devices must also fulfil some qualitative requirements, for example the produced noise level of the devices must be acceptable, the temperature changes in the space caused by the ventilation system must be low enough and the air flow from the supply air device must be comfortable both in low-temperature air and in high temperature air.

Document EP3832223 A1 discloses a method and computer program product for selecting ventilation devices to a ventilation system of a building. In the method the technical properties, i.e. the maximum air flow, the air thrown pattern and the estimated total noise level produced by the ventilation is calculated. A subgroup of potential ventilation devices is first chosen based on the total supply air need and/or extract air need of the building. The ventilation device is chosen from those ventilation devices of the subgroup, which produce the lowest noise level.

Increasing environmental consciousness and global warming makes necessary to pay attention to the carbon dioxide emission of the ventilation systems. Most ventilation device manufacturers already inform the calculated "carbon footprint" value for their products. However, this value only shows the amount of carbon dioxide emission caused by the manufacturing process of each device. The carbon footprint of the ventilation devices may be influenced by the selection of manufacturing or covering materials of the devices. Also the number of ventilation devices in the ventilation system may be varied whereby the overall emissions of the ventilation system change. However, current ventilation systems design methods do not provide simple means for calculating the effect of the manufacturing material selection to the carbon dioxide emissions of the whole ventilation system and means for selecting the ventilation devices based on this information.

Document US 2022/0011731 A1 discloses a HVAC system with sustainability and emissions control. The system may include predictive models configured to predict values of carbon emissions of the HVAC system, when the HVAC system is used.

An object of the invention is to provide a method and computer program product for selecting ventilation devices to a sustainable ventilation system of a space, by which method and computer program product drawbacks related to the prior art can be reduced.

The object of the invention is achieved with a method and computer program product which are characterized in what is disclosed in the independent patent claims. Some preferred embodiments of the invention are disclosed in the dependent claims.

## Summary of the invention

The method according to the invention for selecting ventilation devices to sustainable ventilation system of a space from a group of ventilation devices comprises steps of

- determining a design air flow Qd for the space,
- determining design air flow rate Qv for the ventilation device,
- selecting at least one space related technical property for the ventilation devices,
- determining an approval criterion for selected said at least one space related technical property and
- forming a subgroup of ventilation devices from those ventilation devices fulfilling the approval criterion,

**characterized** in that the method further comprises steps of

- calculating CO2e (carbon dioxide equivalent) for the ventilation devices in the subgroup,
- calculating a comparison value CV for the ventilation devices in the subgroup using equation CV = (design air flow rate Qv of the ventilation device)/(carbon dioxide equivalent (CO2e) of the ventilation device) and
- using comparison value CV as a first selection criterion when selecting ventilation devices to the ventilation system. The space having the ventilation system may be a house, an apartment, a building or any other premises having a measurable volume. Preferably, the calculated CO2e is carbon dioxide equivalent of the manufacturing phase of the ventilation device.

A first preferred embodiment of the method according to the invention further comprises steps of

- defining an initial number of ventilation devices needed in the ventilation system,
- calculating the design air flow rate Qv for the ventilation device and
- evaluating the realisation of the approval criterion of the ventilation device using calculated design air flow rate Qv. Some space related technical properties depend on the air flow rate of the ventilation device. Therefore, the correct determination of the design air flow rate is important when evaluating the fulfilment of the approval criterion. The design air flow rate for the ventilation device can be calculated by a simple division, when the design air flow rate of the space and the initial number of ventilation devices are known.

In a second preferred embodiment of the method according to the invention noise level $L_{pA}$ produced by the ventilation device is used as space related technical property for the ventilation devices.

In another preferred embodiment of the method according to the invention air flow throw length $L_{0,2}$ of the ventilation device is used as space related technical property for the ventilation devices.

Another preferred embodiment of the method according to the invention further comprises steps of

- creating ventilation devices variants having different carbon dioxide equivalent (CO2e) and
- calculating the comparison value CV for each ventilation device variant. The ventilation device variants can be created by choosing different manufacturing materials for the ventilation devices or parts of the ventilation devices. Alternatively or additionally the ventilation device variants can be created by choosing alternative parts, such as nozzles, from a group of interchangeable parts, to the ventilation devices.

Another preferred embodiment of the method according to the invention further comprises steps of

- changing the initial number of ventilation devices,
- calculating a changed design air flow rate Qv for each ventilation device of the subgroup and
- calculating a changed comparison value CV for each ventilation device. The changed number of ventilation devices may be smaller or bigger that the initial number.

Another preferred embodiment of the method according to the invention further comprises steps of

- calculating the total CO2e (carbon dioxide equivalent) for the for the ventilation system and
- suggesting a compensation scheme for compensating the calculated CO2-emissions of the ventilation system. The compensation scheme can be realised by using suitable service provider offering carbon footprint compensating or offsetting projects.

The computer program product according to the invention for selecting ventilation devices to a sustainable ventilation system of a space from a group of ventilation devices comprises,

- code means configured to determine a design air flow Qd for the space,
- code means configured to determine a design air flow rate Qv for the ventilation device,
- code means configured to select at least one space related technical property for the ventilation devices,
- code means configured to determine an approval criterion for selected said at least one space related selected technical property,
- code means configured to form a subgroup of ventilation devices from those ventilation devices fulfilling the approval criterion.

The method further comprises steps of

- code means configured to calculate CO2e (carbon dioxide equivalent) for the ventilation devices in the subgroup
- code means configured to calculate a comparison value CV for the ventilation devices in the subgroup using equation CV = (design air flow rate Qv of the ventilation device)/(carbon dioxide equivalent (CO2e) of the ventilation device) and
- code means configured to use the comparison value CV as a first selection criterion when selecting ventilation devices to the ventilation system.

The first preferred embodiment of the computer program product according to the invention further comprises

- code means configured to define an initial number of ventilation devices needed in the ventilation system,
- code means configured to calculate the design air flow rate Qv for the ventilation device and
- code means configured to evaluate the realisation of the approval criterion of the ventilation device using calculated air flow rate Qv.

The second preferred embodiment of the computer program product according to the invention further comprises code means configured the calculate the noise level $L_{pA}$ produced by the ventilation device and to use the calculated noise level $L_{pA}$ as space related technical property for the ventilation devices.

The third preferred embodiment of the computer program product according to the invention further comprises code means configured to calculate the air flow throw length $L_{0,2}$ of the ventilation device and to use the calculated air flow throw length $L_{0,2}$ as space related technical property for the ventilation devices.

Another preferred embodiment of the computer program product according to the invention further comprises code means configured to

- create ventilation devices variants having different carbon dioxide equivalent (CO2e) and
- to calculate the comparison value CV for each ventilation device variant.

Another preferred embodiment of the computer program product according to the invention further comprises code means configured to

- change the initial number of ventilation devices,
- to calculate a changed design air flow rate Qv for each ventilation device of the subgroup and
- to calculating a changed comparison value CV for each ventilation device.

Another preferred embodiment of the computer program product according to the invention further comprises code means configured to

- calculate the total CO2e (carbon dioxide equivalent) for the ventilation system and
- to suggest a compensation scheme for compensating the calculated CO2-emissions of the ventilation system.

An advantage of the invention is that it helps to make sustainable decisions in the design process of ventilation systems.

A further advantage of the invention is, that it lowers the CO2-emissions, because the invention guides the designers of the ventilation systems towards low-carbon products. The invention also encourages the manufactures to develop ventilation devices having low CO2e -value.

**Brief Description of the Drawings**

In the following the invention will be described in detail, by way of examples, with reference to the accompanying drawings in which,

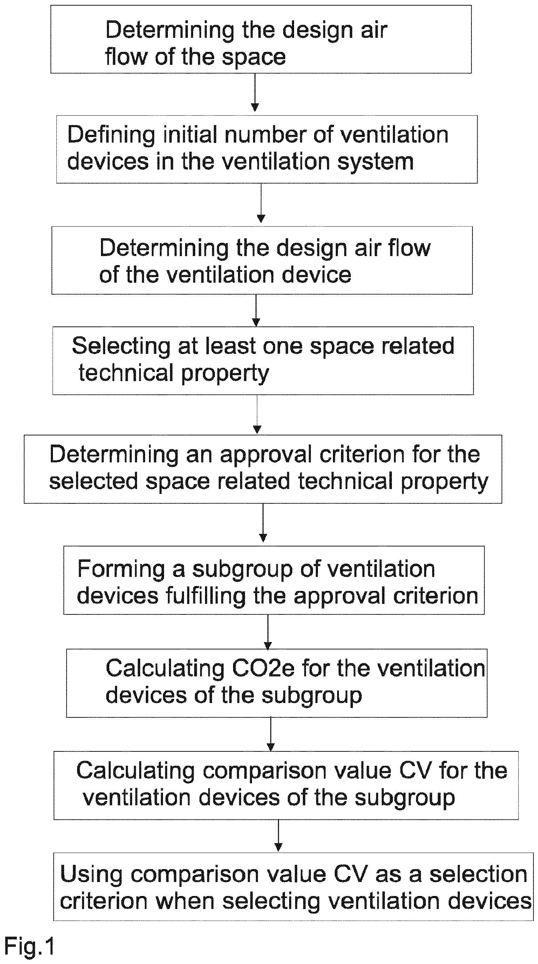

Fig. 1     depicts an example of a method according to the invention as a flow chart.

**Detailed Description**

In figure 1 an example of a method according to the invention is depicted as a flow chart. In the method ventilation devices are selected to a ventilation system of a space from a group of ventilation devices. The space may be a house, an apartment, an office, a premise, a public building, such as a school or a library or any other space wherein people are living, working or visiting. The group of ventilation devices, from which the ventilation devices are selected, may be a product collection of a single manufacturer, seller or importer of ventilation devices or a product collection of a plurality of manufactures, sellers or importers for example. Preferably, the ventilation devices are supply air valves, diffusers or exhaust air valves.

In the method the design air flow Qd of the space is first determined. Building regulations define minimum values for air exchange rates for different kind of premises. As a general rule air exchange rate in living conditions must be at least 0,5-1/h. In conditions, where the quality of the indoor air has higher standards, the minimum value of the air exchange rate can be higher. The total air flow rate can be calculated, when the volume of the space and the air exchange rate is known.

When the design air flow is determined, an initial number of ventilation devices needed in the ventilation system is defined. An initial number can be calculated when the design air flow of the space is known and the "average" value or range of the air flow rate of an individual ventilation device is known. The shape of the space may set some restrictions or requirements for the location of the ventilation devices, which may influence to the definition of initial number of devices. After the initial number of ventilation devices is defined the design air flow rate Qv for each ventilation device is determined. Each ventilation device in the space may have the same air flow rate or different ventilation devices may have different air flow rates.

In the method at least one space related technical property for the ventilation devices is selected and an approval criterion for the selected space related technical property is determined. Term "space related" means here, that the technical property somehow depends on the purpose of use of the space or the planned activity in the space sets some technical requirements to the ventilation devices in the space. Preferably, the noise level produced by the ventilation device is used as a first space related technical property for the ventilation devices.

The ventilation devices produce airborne noise when they are installed in place to the ventilation system and the system is in operation. The noise is caused by the air flowing through the holes or gaps of the ventilation device. The calculation of the estimated noise level in a noise evaluation point can be done by known calculation methods, when distance between the noise evaluation point and the ventilation device is known. The noise level is actually a frequency weighted noise pressure level. Noise pressure levels can be weighted by A-, B- or C-weighting factors. When designing ventilation systems for building, A-weighting factors is most often used. The acceptable noise level of the space can be taken from the building regulations or it can be chosen by the designer of the ventilation system. The equations used in the calculations can be found for example from a textbook "Ilmastointilaitoksen mitoitus: Ilmastointitekniikka: osa 2; Esa Sandberg, 2014".

Preferably an air flow throw length $L_{0,2}$ of the ventilation device is used as a second space related technical property for the ventilation devices in the method. The air flow throw length tells how far the air flow spreads from the ventilation device, i.e from the supply air valve or diffuser. It is clear, that the fresh air flow should reach substantially all places of the space. Therefore, the minimum value of preferred value for the throw length is easy to calculate, when the dimension of the space and the potential locations of the ventilation devices inside said space are known. The minimum value or preferred value can be used as an approval criterion for the flow throw length.

It is also possible to select other space related technical properties for the ventilation device. Such properties may for example relate to the technical quality of the ventilation device. The purpose of use of the space or the building regulations for example may contain material requirements, surface treatment requirements and/or strength requirements, which the ventilation device must fulfil.

In the method the realisation of the approval criterion is evaluated or calculated. When the technical property depends on the air flow rate of the ventilation device, the realisation of the approval criterions is evaluated or calculated using the previously determined design air flow rate Qv of the ventilation device.

Those ventilation devices, which fulfil the approval criterions of all selected space related technical properties constitute a subgroup, from which the final selection of the ventilation devices is done.

In the method CO2e (carbon dioxide equivalent) is calculated for the ventilation devices in the subgroup. The calculation can be done by any suitable and reliable calculation method used in the market. Preferably the calculation is made according to EN 15804 EPD standard. After that a comparison value CV for each ventilation device in the subgroup is calculated using equation CV = (design air flow rate Qv of ventilation device)/(carbon dioxide equivalent (CO2e) of the ventilation device). The calculated comparison value CV is used as a first selection criterion when selecting ventilation devices to the ventilation system from the subgroup.

When comparing the ventilation devices of the subgroup different variants of the ventilation devices can be created. Variants can be created by chancing the manufacturing materials of the whole device or parts of the device. Most ventilation devices can be made of metal, plastic or wood-composite material or they may contain interchangeable parts, such as nozzles, made of metal, plastic or wood-composite. Changing the manufacturing material of the device or part of the device the functional and technical properties of the device remain substantially unchanged, but the carbon dioxide equivalent of the device may change significantly. Thus, in the method variants can be made simply by altering the manufacturing material combinations of the devices in a way, that the variants automatically fulfil the approval criterions of all selected space related technical properties. For each variant created in the method an own comparison value CV is calculated and the suitability of the variant to the ventilation system is evaluated based on calculated comparison value.

The initial number of the ventilation devices is determined in early stage of the method to be able to calculate a design air flow rate Qv for the ventilation device. This design air flow rate is then used in subsequent calculations of air flow dependent characteristics, such as noise level and air flow throw length. During further steps of the method the determined initial number of ventilation devices can be changed, i.e. lowered or increased. Chancing the number of ventilation devices in the ventilation system of course affects to the air flow rate of individual ventilation device. Therefore, also a new design air flow rate and a new comparison value CV is calculated for each ventilation device in the subgroup. Further, cross-check calculations to verify, that the space related technical properties are fulfilled also with changed design air flow rate Qv of the ventilation device, should be made.

A preferred embodiment of the invention further comprises steps of selecting at least one device related technical property for the ventilation devices and determining an approval criterion for said at least one device related selected technical property. Realisation of the approval criterion of said at least one device related selected technical property is evaluated and the outcome of this evaluation is used as a second selection criterion when selecting ventilation devices to the ventilation system.

Each ventilation device has individual device related technical properties, such as air exit velocity $v_0$ and throw length factor m. The air exit velocity depends for example on the number and shape of the openings in front plate of the ventilation device, i.e. the free face area of the ventilation device. The throw length depends on the air exit velocity whereby the throw length factor is also an individual device related technical property. The relation of these device related factors can be expressed by known equation

$$v_x/v_0 = m\ \sqrt{(A_0)}/x,$$

where

$v_x$ = air velocity at distance x from the ventilation device
$v_0$ = air exit velocity
m = throw length factor
$A_0$ = free face area of the ventilation device

Target value for the air velocity $v_x$ in the middle of the room may be 0,2 m/s.

Design air flow Qv of the ventilation device can be calculated using known equation

$$Qv = v_0 * A_0.$$

The approval criteria for the device related technical properties may be for example

- design air flow Qv 30 dm$^3$/s
- throw length factor m=1,2
- air exit velocity $v_0$= 2,7 m/s when thrown length $L_{0,2}$ is 2 m.

In the method a ventilation device is selected from those devices or device variants of the subgroup which fulfil the device related technical properties and have the lowest comparison value CV. The selected ventilation device can for example be a device having visible composite surface covering and an inner structure comprising 2,5 kg steel and 0,3 kg plastic.

In the method a clear numerical figure, namely the comparison value CV is obtained for each ventilation device, which helps to select a ventilation device to ventilation system of a space in a sustainable manner. The comparison value expresses the sustainability of the ventilation device as a single number having unit $[(m^3/h)/(CO2e/m^3)]$.

Once the selection of the ventilations devices is done the number and type of the ventilation devices is confirmed. Preferably the method further comprises steps of calculating the total CO2e (carbon dioxide equivalent) for the for the ventilation system. The method may further suggest compensating the calculated CO2-emission wholly or partly using known compensation schemes.

Preferably, the selected ventilation devices are furnished with a tag identifying the ventilation device. The tag may be attached to the ventilation device itself or to the sales package of the device. The information carried by the tag preferably includes at least the calculated comparison value and other relevant data, such as technical specifications and delivery and installing information.

The method steps of the invention are coded to a computer program product, which carries out the method steps, when the program is executed in a processor of a computer. The realisation of some steps may require actions or input from the user of the computer program. In these steps the computer program assists the user to make rational and reasoned actions and selections by producing relevant information and/or proposing alternatives for the user.

Some preferred embodiments of invention have been disclosed above. The invention is not limited to the solutions explained above, but the invention can be applied in different ways within the limits set by the patent claims.

**Claims**

1. A method for selecting ventilation devices to a sustainable ventilation system of a space from a group of ventilation devices, said method comprising steps of,

    - determining a design air flow (Qd) for the space,
    - determining a design air flow rate (Qv) for the ventilation device
    - selecting at least one space related technical property for the ventilation devices,
    - determining an approval criterion for selected said at least one space related technical property and
    - forming a subgroup of ventilation devices from those ventilation devices fulfilling the approval criterion,

    **characterized in that** the method further comprises steps of

    - calculating CO2e (carbon dioxide equivalent) for the ventilation devices in the subgroup,
    - calculating a comparison value CV for the ventilation devices in the subgroup using equation CV = (design air flow rate (Qv) of the ventilation device)/(carbon dioxide equivalent (CO2e) of the ventilation device) and
    - using comparison value CV as a first selection criterion when selecting ventilation devices to the ventilation system.

2. A method according to claim 1, **characterized in that** the method further comprises steps of

    - defining an initial number of ventilation devices needed in the ventilation system,
    - calculating design air flow rate (Qv) for the ventilation device and
    - evaluating the realisation of the approval criterion of the ventilation device using calculated design air flow rate (Qv).

3. A method according to claim 1 or 2, **characterized in that** noise level $L_{pA}$ produced by the ventilation device is used as space related technical property for the ventilation devices.

4. A method according to any of the claims 1 to 3, **characterized in that** air flow throw length $L_{0,2}$ of the ventilation device is used as space related technical property for the ventilation devices.

**5.** A method according to any of the claims 1 to 4, **characterized in that** the method further comprises steps of

- creating ventilation devices variants having different carbon dioxide equivalent (CO2e) and
- calculating the comparison value CV for each ventilation device variant.

**6.** A method according to claim 5, **characterized in that**, the ventilation device variants are created by choosing different manufacturing materials for the ventilation devices or parts of the ventilation devices or the ventilation device variants are created by choosing alternative parts, such as nozzles, from a group of interchangeable parts, to the ventilation devices.

**7.** A method according to any of the claims 2 to 6, **characterized in that** the method further comprises steps of

- changing the initial number of ventilation devices,
- calculating a changed design air flow rate (Qv) for each ventilation device of the subgroup and
- calculating a changed comparison value CV for each ventilation device.

**8.** A method according to any of the claims 1 to 7, **characterized in that** the method further comprises steps of

- calculating the total CO2e (carbon dioxide equivalent) for the for the ventilation system and
- suggesting a compensation scheme for compensating the calculated CO2-emissions of the ventilation system.

**9.** A computer program product for selecting ventilation devices to a sustainable ventilation system of a space from a group of ventilation devices, said computer program product comprising,

- code means configured to determine a design air flow (Qd) for the space,
- code means configured to determine a design air flow rate (Qv) for the ventilation device
- code means configured to select at least one space related technical property for the ventilation devices,
- code means configured to determine an approval criterion for selected said at least one space related selected technical property,
- code means configured to form a subgroup of ventilation devices from those ventilation devices fulfilling the approval criterion,

**characterized in that** the method further comprises steps of

- code means configured to calculate CO2e (carbon dioxide equivalent) for the ventilation devices in the subgroup
- code means configured to calculate a comparison value CV for the ventilation devices in the subgroup using equation CV = (design air flow rate (Qv) of the ventilation device)/(carbon dioxide equivalent (CO2e) of the ventilation device) and
- code means configured to use the comparison value CV as a first selection criterion when selecting ventilation devices to the ventilation system.

**10.** A computer program product according to claim 9, **characterized in that** the computer program product further comprises

- code means configured to define an initial number of ventilation devices needed in the ventilation system,
- code means configured to design calculate air flow rate (Qv) for the ventilation device and
- code means configured to evaluate the realisation of the approval criterion of the ventilation device using calculated air flow rate (Qv).

**11.** A computer program product according to claims 9 or 10, **characterized in that** the computer program product further comprises code means configured to calculate the noise level $L_{pA}$ produced by the ventilation device and to use the calculated noise level $L_{pA}$ as space related technical property for the ventilation devices.

**12.** A computer program product according to any of the claims 9 to 11, **characterized in that** the computer program product further comprises code means configured the calculate the air flow throw length $L_{0,2}$ of the ventilation device and to use the calculated the air flow throw length $L_{0,2}$ as space related technical property for the ventilation devices.

**13.** A computer program product according to any of the claims 9 to 12, **characterized in that** the computer program product further comprises code means configured to

- create ventilation devices variants having different carbon dioxide equivalent (CO2e) and
- to calculate the comparison value CV for each ventilation device variant.

**14.** A computer program product according to any of the claims 10 to 13, **characterized in that** the computer program product further comprises code means configured to

- change the initial number of ventilation devices,
- to calculate a changed design air flow rate (Qv) for each ventilation device of the subgroup and
- to calculating a changed comparison value CV for each ventilation device.

15. A computer program product according to any of the claims 9 to 14, **characterized in that** the computer program product further comprises code means configured to

- calculate the total $CO_2e$ (carbon dioxide equivalent) for the ventilation system and
- to suggest a compensation scheme for compensating the calculated $CO_2$-emissions of the ventilation system.

Determining the design air
flow of the space

Defining initial number of ventilation
devices in the ventilation system

Determining the design air flow
of the ventilation device

Selecting at least one space related
technical property

Determining an approval criterion for the
selected space related technical property

Forming a subgroup of ventilation
devices fulfilling the approval criterion

Calculating CO2e for the ventilation
devices of the subgroup

Calculating comparison value CV for the
ventilation devices of the subgroup

Using comparison value CV as a selection
criterion when selecting ventilation devices

Fig.1

Europäisches
Patentamt

European
Patent Office

Office européen
des brevets

# EUROPEAN SEARCH REPORT

Application Number

EP 23 16 5475

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y,D | EP 3 832 223 A1 (CLIMECON OY [FI]) 9 June 2021 (2021-06-09) * paragraphs [0006] - [0032]; figure 1 * ----- | 1-15 | INV. F24F11/00 F24F13/24 |
| Y,D | US 2022/011731 A1 (RISBECK MICHAEL J [US] ET AL) 13 January 2022 (2022-01-13) * paragraphs [0271] - [0272]; figures 1-30 * ----- | 1-15 | |
| A | US 2014/149270 A1 (LOMBARD STUART [CA] ET AL) 29 May 2014 (2014-05-29) * paragraph [0040]; figures 1-5 * ----- | 1-15 | |

| | TECHNICAL FIELDS SEARCHED (IPC) |
|---|---|
| | F24F |

The present search report has been drawn up for all claims

| Place of search | Date of completion of the search | Examiner |
|---|---|---|
| Munich | 19 September 2023 | Ismail, Youssef |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 16 5475

This annex lists the patent family members relating to the patent documents cited in the above-mentioned European search report.
The members are as contained in the European Patent Office EDP file on
The European Patent Office is in no way liable for these particulars which are merely given for the purpose of information.

19-09-2023

| Patent document cited in search report | | Publication date | Patent family member(s) | | Publication date |
|---|---|---|---|---|---|
| EP 3832223 | A1 | 09-06-2021 | EP 3832223 A1 | | 09-06-2021 |
| | | | FI 20196051 A1 | | 15-03-2021 |
| US 2022011731 | A1 | 13-01-2022 | NONE | | |
| US 2014149270 | A1 | 29-05-2014 | CA 2834642 A1 | | 26-05-2014 |
| | | | US 2014149270 A1 | | 29-05-2014 |

For more details about this annex : see Official Journal of the European Patent Office, No. 12/82

## REFERENCES CITED IN THE DESCRIPTION

**Patent documents cited in the description**

- EP 3832223 A1

- US 20220011731 A1

**Non-patent literature cited in the description**

- **ESA SANDBERG.** Ilmastointilaitoksen mitoitus: Il-mastointitekniikka. 2014